Europäisches Patentamt

European Patent Office

Office européen des brevets

(11) Veröffentlichungsnummer: **0 257 505**
**A2**

(12) **EUROPÄISCHE PATENTANMELDUNG**

(21) Anmeldenummer: 87111880.8

(51) Int. Cl.⁴: **G03F 7/02**

(22) Anmeldetag: 17.08.87

(30) Priorität: 23.08.86 DE 3628720

(43) Veröffentlichungstag der Anmeldung:
02.03.88 Patentblatt 88/09

(84) Benannte Vertragsstaaten:
DE FR GB

(71) Anmelder: **HOECHST AKTIENGESELLSCHAFT**
**Postfach 80 03 20**
**D-6230 Frankfurt am Main 80(DE)**

(72) Erfinder: **Herrmann, Heinz. Dr.**
**Am Güldenplan 15**
**D-6200 Wiesbaden(DE)**
Erfinder: **Schlosser, Hans-Joachim, Dr.**
**Am Rosengarten 2a**
**D-6200 Wiesbaden(DE)**
Erfinder: **Billino, Susanne**
**Erfurter Strasse 1**
**D-6090 Rüsselsheim(DE)**

(54) **Vorsensibilisierte Druckplatte und Verfahren zur Herstellung einer Druckform für den wasserlosen Flachdruck.**

(57) Es wird eine vorsensibilisierte Druckplatte für den wasserlosen Flachdruck mit einem Schichtträger, einer strahlungsempfindlichen Schicht, die

a) eine Verbindung mit mindestens einer durch Säure spaltbaren C-O-C-Bindung,

b) eine bei Bestrahlung eine starke Säure bildende Verbindung und

c) ein in Wasser unlösliches Bindemittel enthält, einer äußeren, Druckfarbe abweisenden vernetzten Silikonkautschukschicht und einer Zwischenschicht beschrieben, die die Haftung der Silikonkautschukschicht auf der strahlungsempfindlichen Schicht verbessert.

Die Druckplatte hat eine wesentlich höhere Lichtempfindlichkeit als bekannte negativ arbeitende wasserlos druckende Offsetdruckplatten.

EP 0 257 505 A2

## Vorsensibilisierte Druckplatte und Verfahren zur Herstellung einer Druckform für den wasserlosen Flachdruck

Die Erfindung betrifft eine vorsensibilisierte Druckplatte für den wasserlosen Flachdruck, insbesondere Offsetdruck, sowie ein Verfahren zur Herstellung einer Druckform durch Belichten und Entwickeln dieser Druckplatte. Die erfindungsgemäße Druckplatte weist einen Schichtträger, eine strahlungsempfindliche Schicht und eine äußere, Druckfarbe abweisende Schicht aus Silikongummi auf.

Druckplatten dieses Schichtaufbaus mit positiv und negativ arbeitenden strahlungsempfindlichen, insbesondere lichtempfindlichen Schichten sind z. B. aus der US-A 3 511 178 bekannt. Als negativ arbeitende, d. h. lichthärtbare lichtempfindliche Verbindungen werden Diazoniumsalz-Kondensationsprodukte eingesetzt. Die belichtete Druckplatte wird mit einer Lösung entwickelt, die die unbelichteten Bereiche der lichtempfindlichen Schicht löst und die Silikongummischicht anquellt. Dabei lassen sich die über den löslichen Schichtbereichen liegenden Silikongummibereiche durch Reiben entfernen. Die erhaltene Druckform nimmt an den freigelegten Bereichen des Schichtträgers Druckfarbe an, während die an den unbelichteten Stellen stehengebliebene Silikongummischicht Druckfarbe abweist. Sie druckt also ein Negativ der verwendeten Belichtungsvorlage. Als positiv arbeitende Verbindungen werden unlösliche Fällungsprodukte von Diazoniumsalzen und Phosphorwolframsäure eingesetzt. In diesem Fall wird zur Verankerung der Silikongummischicht auf der lichtempfindlichen Schicht eine Zwischenschicht aus einem Diazoniumsalz-Formaldehydkondensat zwischen diesen Schichten vorgesehen. Diese Zwischenschicht wird beim Aushärten der Silikonkautschukschicht zur Silikongummischicht durch Erwärmen vernetzt und bewirkt dann die gewünschte verbesserte Haftung.

Es sind auch wasserlos druckende Flachdruckplatten mit anderen durch Belichten löslich werdenden Schichten bekannt. In praktisch allen Fällen ist eine entsprechende Haftschicht erforderlich und beschrieben.

Gemäß der DE-A 29 43 379 wird eine lichtempfindliche Schicht aus o-Chinondiazid und Novolak eingesetzt, auf die eine Zwischenschicht aus einem haftvermittelnden Aminoalkyl-alkoxysilan aufgebracht wird.

In der DE-A 3 045 979 (= US-A 4 342 820) ist die Kombination einer speziellen o-Chinondiazidschicht mit einer Silikongummischicht beschrieben. Zur Verbesserung der Haftung zwischen diesen Schichten können einer dieser Schichten Silikone oder Silane zugesetzt werden, oder es kann eine Haftschicht aus solchen Verbindungen zwischen diesen Schichten aufgebracht werden.

Gemäß der JP-A 58/60744 wird die Haftung durch Zusatz von Aminosilan und Tetraisopropoxytitan zur Silikon schicht oder durch eine Haftschicht aus Organotitanverbindungen erreicht.

In der EP-A 100 938 wird ein Verfahren zur Verbesserung der Haftung entsprechender Schichten durch kurzes Anbelichten und Behandeln mit einer Base, z. B. einem primären Amin, beschrieben. Es kann auch zusätzlich eine Zwischenschicht aus Aminosilanen und bzw. oder Organotitanaten aufgebracht werden.

In der EP-A 154 980 wird eine ähnliche vorsensibilisierte Druckplatte beschrieben, die in der lichtempfindlichen o-Chinondiazidschicht zusätzlich eine Kupplungskomponente enthält, die im basischen Medium, z. B. bei der Entwicklung, mit der unzersetzten Diazoverbindung in den unbelichteten Bereichen zu einem schwerlöslichen Azofarbstoff kuppelt. Während der Kupplungsreaktion tritt zugleich eine verstärkte Verankerung der Silikonschicht auf der Chinondiazidschicht ein. Zusätzlich kann noch eine Haftschicht zwischen diesen Schichten, z. B. aus Aminosilanen oder Organotitanverbindungen, vorgesehen sein.

Diese bekannten negativ arbeitenden Druckplatten für den wasserlosen Offsetdruck auf Basis von Diazoniumsalzen oder Chinondiaziden haben nur eine relativ niedrige Lichtempfindlichkeit. Die Haftung läßt sich oft nur durch komplizierten Aufbau des Materials und zusätzliche Verfahrensschritte verbessern. Zur Entwicklung dieser Druckplatten sind in den meisten Fällen Gemische aus wasserunlöslichen und polaren organischen Lösemitteln erforderlich. Die in einigen Fällen verwendbaren Gemische aus wassermischbaren Lösemitteln und Wasser bestehen mindestens zum überwiegenden Teil aus organischen Lösemitteln. Dieser hohe Lösemittelgehalt erfordert beim Gebrauch besondere Maßnahmen, um Abluft und Abwasser nicht über das zulässige Maß zu belasten.

Es sind auch positiv arbeitende lichtempfindliche Gemische auf Basis von photolytisch Säure bildenden Verbindungen und durch Säure spaltbaren Verbindungen, z. B. Orthocarbonsäureestern und Acetalen, bekannt. Diese Gemische ergeben lichtempfindliche Schichten, z. B. für Druckplatten, mit wesentlich höherer Lichtempfindlichkeit als sie Naphthochinondiazidschichten aufweisen; sie werden z. B. in den DE-C 26 10 842 und 27 18 254 und der EP-B 22 571 beschrieben.

Aufgabe der Erfindung war es, eine negativ arbeitende Druckplatte für den wasserlosen Offsetdruck vorzuschlagen, die eine höhere Lichtempfindlichkeit als die bisher bekannten Druckplatten gleicher Art aufweist, die sich mit Entwicklerlösungen verarbeiten läßt, die zum überwiegenden Teil aus Wasser bestehen, und die eine haftfest auf der lichtempfindlichen Schicht verankerte vernetzte Silikonkautschukschicht aufweist.

Erfindungsgemäß wird eine vorsensibilisierte Druckplatte für den wasserlosen Flachdruck mit einem Schichtträger, einer durch Belichtung löslich werdenden strahlungsempfindlichen Schicht, einer äußeren, Druckfarbe abweisenden vernetzten Silikonkautschukschicht und einer Zwischenschicht vorgeschlagen, die die Haftung der Silikonkautschukschicht auf der strahlungsempfindlichen Schicht verbessert.

Die erfindungsgemäße Druckplatte ist dadurch gekennzeichnet, daß die strahlungsempfindliche Schicht als wesentliche Bestandteile

a) eine Verbindung mit mindestens einer durch Säure spaltbaren C-O-C-Bindung,

b) eine bei Bestrahlung eine starke Säurebildende Verbindung und

c) ein in Wasser unlösliches Bindemittel enthält und die Zwischenschicht aus amorpher Kieselsäure besteht.

Erfindungsgemäß wird ferner ein Verfahren zur Herstellung einer Druckform für den wasserlosen Flachdruck vorgeschlagen.

Das erfindungsgemäße Verfahren ist dadurch gekennzeichnet, daß man eine vorsensibilisierte Flachdruckplatte der vorstehend beschriebenen Beschaffenheit bildmäßig belichtet, in eine ein mit Wasser mischbares organisches Lösungsmittel enthaltende wäßrige Lösung eintaucht und danach an den belichteten Stellen die lichtempfindliche Schicht zusammen mit der darüberliegenden Silikongummischicht durch Reiben entfernt.

Die in den erfindungsgemäßen Druckplatten enthaltene Zwischenschicht wird vorzugsweise durch Aufbringen eines verdünnten Kieselsäuresols auf die strahlungs-, insbesondere lichtempfindliche Schicht und Trocknen des Sols erzeugt.

Ohne Anwendung dieser Haftschicht weisen Silikongummischichten auf lichtempfindlichen Schichten auf Basis säurespaltbarer Materialien eine völlig unzureichende Haftung auf. Wie gefunden wurde, ergeben die auf Naphthochinondiazidschichten üblichen Haftschichten aus Silanen, z. B. Aminoalkylsilanen, zwar eine gewisse Verbesserung der Haftung gegenüber der unbelichteten säurespaltbaren Schicht. Sie stören jedoch die Verarbeitung der damit hergestellten Druckplatte, oder die Verankerung ist so schlecht, daß sich die Platte nach bildmäßiger Belichtung nicht zu einer brauchbaren Druckschablone entwickeln läßt.

Die zur Herstellung der Haftschichten verwendeten Kieselsäuresole enthalten im allgemeinen Kieselsäurepartikel einer Größe von 5 bis 150, vorzugsweise von 20 bis 50 nm. Geeignet sind sowohl alkalisch als auch sauer stabilisierte wäßrige Kieselsäuresole. Zur besseren Benetzung der lichtempfindlichen Schicht wird dem Sol vorteilhaft eine kleine Menge eines wasserlöslichen Netzmittels, insbesondere eines anionischen oder nichtionischen Netzmittels zugesetzt. Geeignet sind z. B. Alkalisalze von langkettigen Alkansäuren, Alkylsulfonsäuren, Monoalkylsulfaten, Alkylbenzol sulfonsäuren und Polyalkoxyphenolether. Da die Netzmittel selbst einer guten Haftung entgegenwirken, sollte vorzugsweise die Menge an Netzmittel möglichst niedrig gehalten werden. Bevorzugt werden im allgemeinen Mengen von 1 bis 15 Gew.-%, bezogen auf den Feststoffgehalt des Sols.

Eine besonders gute Verankerung der Kieselsäureschicht auf der lichtempfindlichen Schicht erreicht man, wenn das Kieselsäuresol etwas in die lichtempfindliche Schicht eindiffundieren kann. Da die Eindringtiefe bei zunehmendem Trocknungsgrad der lichtempfindlichen Schicht zurückgeht, ist es ratsam, die Haftschicht auf möglichst schwach getrocknete Schichten aufzutragen. Die Diffusion kann zudem durch Beimischen wassermischbarer Lösemittel, die die Positivschicht anquellen, zum Kieselsäuresol gesteuert werden. Auch eine Vergrößerung der Oberfläche der lichtempfindlichen Schicht durch mechanisches Aufrauhen oder durch Pigmentierung führt zu verstärkter Haftung der Kieselsäureschicht.

Außer den erforderlichen Netz-und eventuell wassermischbaren Lösemitteln können die Kieselsäuresoleauch noch feinteilige Füllstoffe enthalten.

Das Schichtgewicht der Kieselsäureschicht kann in weiten Grenzen schwanken, etwa zwischen 0,01 und 1,0 g/m². Es liegt vorzugsweise zwischen 0,1 und 0,3 g/m².

Die durch Bestrahlung löslich werdende Schicht kann als Verbindungen mit säurespaltbaren C-O-C-Bindungen unter anderem monomere und polymere Acetale, monomere und polymere Orthocarbonsäureester, Enolether und N-Acyliminocarbonate enthalten. Solche Gemische sind in den EP-A 6626 und 6627 sowie in den eingangs genannten Druckschriften beschrieben. Dabei werden polymere Acetale und Orthocarbonsäureester besonders bevorzugt. Der Mengenanteil an säurespaltbarer Verbindung beträgt im allgemeinen 2 bis 75, vorzugsweise 4 bis 30 Gew.-%, bezogen auf die nichtflüchtigen Bestandteile der Schicht.

Als strahlungsempfindliche Komponenten, die beim Bestrahlen vorzugsweise starke Säuren bilden bzw. abspalten, sind eine große Anzahl von bekannten Verbindungen und Mischungen, wie Diazonium-, Phosphonium-, Sulfonium-und Jodonium-Salze, Halogen-Verbindungen, o-Chinondiazidsulfochloride und Organometall-Organohalogen-Kombinationen geeignet.

Grundsätzlich sind als halogenhaltige strahlungsempfindliche und Halogenwasserstoffsäure bildende Verbindungen alle auch als photochemische Radikalstarter bekannten organischen Halogenverbindungen, beispielsweise solche mit mehr als einem Halogentom an einem Kohlenstoffatom oder an einem aromatischen Ring, brauchbar. Beispiele sind in den US-A 3 515 552, 3 536 489 und 3 779 778, der DE-B 26 10 842 und den DE-A 27 18 259 und 22 43 621 beschrieben.

Die Menge des Starters kann je nach seiner chemischen Natur und der Zusammensetzung des Gemischs ebenfalls sehr verschieden sein. Günstige Ergebnisse werden erhalten mit etwa 0,1 bis 10 Gew.-%, bezogen auf den Gesamtfeststoff, bevorzugt sind 0,2 bis 5 %.

Die Gemische enthalten ferner ein polymeres, wasserunlösliches Bindemittel, das in organischen Lösemitteln löslich ist. Da sich als Entwicklerflüssigkeiten für die belichteten Kopierschichten mit Vorteil wäßrig-alkalische Lösungen einsetzen lassen, werden insbesondere solche Bindemittel bevorzugt, die in wäßrigen Alkalien löslich oder mindestens quellbar sind. Die Art und Menge der wasserunlöslichen Bindemittel kann je nach Anwendungszweck verschieden sein; bevorzugt sind Anteile am Gesamtfeststoff zwischen 30 und 90, besonders bevorzugt 55 - 85 Gew.-%.

Phenolharze, vor allem Novolake, haben sich als besonders vorteilhaft erwiesen. Andere alkalilösliche Harze, wie Mischpolymerisate aus Maleinsäureanhydrid und Styrol, Vinylacetat und Crotonsäure, Methylmethacrylat und Methacrylsäure und dgl. sind ebenfalls als Binde mittel geeignet.

Die lichtempfindliche Schicht kann ferner Farbstoffe oder feinteilige Farbpigmente enthalten. Besonders bewährt haben sich Triphenylmethanfarbstoffe, insbesondere in Form ihrer Carbinolbasen.

Das Gewicht der lichtempfindlichen Schicht liegt im allgemeinen bei 0,3 bis 3 g/m², Schichtgewichte von etwa 0,8 bis 1,8 g/m² werden in den meisten Fällen bevorzugt.

Die Silikonkautschukschicht wird aus einer Lösung in einem unpolaren Lösungsmittel, z. B. aliphatischen oder aromatischen Kohlenwasserstoffen, aufgebracht, in dem sich die Bestandteile der Haftschicht und der lichtempfindlichen Schicht unter den Beschichtungsbedingungen praktisch nicht auflösen.

Grundsätzlich ist jeder Silikonkautschuk geeignet, der ausreichend farbabweisend ist, um ein Drucken im Offsetdruck ohne Feuchtwasser zu erlauben. Als "Silikonkautschuk" soll im Rahmen dieser Erfindung entsprechend der Definition von Noll, "Chemie und Technologie der Silikone", Verlag Chemie, 1968, S. 332, ein hochmolekulares, im wesentlichen lineares Diorganopolysiloxan bezeichnet werden, während für die vernetzten bzw. vulkanisierten Produkte die Bezeichnung "Silikongummi" verwendet wird. In jedem Fall wird eine Silikonkautschuklösung auf die lichtempfindliche Schicht aufgebracht, getrocknet und dann vernetzt.

Als Silikonkautschuke sind Einkomponenten- und Mehrkomponententypen geeignet, wie sie z. B. in den DE-A 23 50 211, 23 57 871 und 23 59 102 beschrieben sind.

Die Einkomponenten-Silikonkautschuke basieren auf Polysiloxanen, die z. B. endständige Acetyl-, Oxim-, Alkoxy-oder Aminogruppen oder Wasserstoffatome enthalten. Im übrigen besteht das Polysiloxan im wesentlichen aus einer Dimethylpolysiloxankette. Die Methylgruppen können in geringerem Umfang auch durch andere Alkylgruppen, durch Halogenalkylgruppen oder substituierte oder unsubstituierte Arylgruppen ersetzt sein. Die endständigen funktionellen Gruppen sind leicht hydrolysierbar und härten bei Feuchtigkeitseinwirkung innerhalb von einigen Minuten bis Stunden bei Raumtemperatur aus (RTV-1-Silikonkautschuke).

Die Mehrkomponenten-Silikonkautschuke können durch Addition oder durch Kondensation vernetzbar sein. Die additionsvernetzbaren Typen enthalten im allgemeinen Polysiloxane mit Alkenylgruppen als Substituenten und solche mit an Silicium gebundenen Wasserstoffatomen. Sie werden in Gegenwart von Platinkatalysatoren bei Temperaturen oberhalb 50 C vernetzt. Sie haben den Vorteil, daß sie bei höherer Temperatur, z. B. um 100 C, schnell vernetzen. Dafür kann auch die Verarbeitungsdauer (Topfzeit) dieser Systeme relativ kurz sein.

Die durch Kondensation vernetzbaren Gemische enthalten Diorganopolysiloxane mit reaktionsfähigen Endgruppen, z. B. OH-und Acetoxygruppen. Diese werden mit reaktiven Silanen oder Oligosiloxanen, z. B. Alkoxy-oder Acetoxysilanen oder Siloxanen, die mehrere Si-H-Gruppen im Molekül enthalten, in Gegenwart von Katalysatoren, wie Organozinnverbindungen, z. B. Dialkylzinndiacetat, vernetzt. Auch diese Kombinationen reagieren relativ schnell und haben deshalb eine begrenzte Topfzeit.

Mit besonderem Vorteil werden durch Kondensation vernetzbare Mehrkomponenten-Silikonkautschuke eingesetzt. Der bevorzugte Vernetzer ist Vinyl-triacetoxy-silan. Mit ihm erhält man die beste Haftung auf der Kieselsäureschicht und damit auf der lichtempfindlichen Schicht. Vinyl-triacetoxysilan kann aber auch in Kombination mit anderen Vernetzern verwendet werden, solange diese nicht die Solubilisationsreaktion in der lichtempfindlichen Schicht stören. Ausreichende Haftung in Abwesenheit von Alkyl-triacetoxy-silanen erhält man auch mit H-haltigen Siloxanen. Da die Haftung in den ersten Tagen nach Herstellung der Druckplatten noch deutlich zunimmt, sollten aber solche Platten erst nach mehrtägiger Lagerung verarbeitet werden.

Die Konzentration des Vernetzers oder des VernetzerGemisches beträgt üblicherweise 1 - 20 % der Polysiloxanmenge, vorzugsweise 2 - 15 %. Die Katalysatormenge liegt vorzugsweise bei etwa 2 bis 10 Gew.-% des Polysiloxananteils.

Die Silikonkautschuke werden nach dem Aufbringen als Schicht in bekannter Weise durch Feuchtigkeitseinwirkung oder aus sich heraus bei Raumtemperatur oder erhöhter Temperatur zu einem in organischen Lösungsmitteln im wesentlichen unlöslichen Silikongummi vernetzt. Die fertige Silikongummischicht hat im allgemeinen ein Gewicht von 1 bis 20, bevorzugt von 2 bis 6 g/m².

Die dehäsive Silikongummischicht verankert sich vermutlich durch eine chemische Reaktion auf der Kieselsäureschicht. Es wird angenommen, daß eine Kondensationsreaktion eintritt zwischen den an der Oberfläche der Kieselsäureteilchen liegenden Hydroxylgruppen und den Hydroxylgruppen der hochmolekularen unvernetzten Silikonkautschuke.

Die bevorzugten Mehrkomponenten-Silikonkautschuke haben den Vorteil, daß damit hergestellte Druckplatten beim Drucken ohne Feuchtwasser eine wesentlich geringere Neigung zum Tonen aufweisen als solche, die mit normalen Einkomponenten-Silikonkautschuken hergestellt worden sind. Auch die Kratzfestigkeit der Oberfläche des gehärteten Silikongummis ist bei den bevorzugten Verbindungstypen erhöht.

Als Schichtträger werden meist Metalle verwendet. Für Offsetdruckplatten können eingesetzt werden: walzblankes, mechanisch oder elektrochemisch aufgerauhtes und gegebenenfalls anodisiertes Aluminium, das zudem noch chemisch, z. B. mit Polyvinylphosphonsäure, Silikaten, Phosphaten, Hexafluorozirkonaten oder mit hydrolysiertem Tetraethylorthosilikat, vorbehandelt sein kann. Weitere geeignete Metalle sind Stahl und Chrom. Da es, im Gegensatz zu üblichen Flachdruck platten, nicht erforderlich ist, daß die Trägeroberfläche hydrophil ist, können mit Vorteil auch Kupfer, Messing oder andere oleophile Metalle als Trägeroberfläche dienen. Die Trägeroberfläche kann auch eine dauerhafte oleophile Beschichtung tragen, z. B. eine Haftvermittlerschicht. Ferner können Kunststoffolien, wie Polyester-, Polycarbonat-, Polyimid-oder auch Celluloseacetatfolien verwendet werden, deren Oberfläche ggf. zur Erhöhung der Benetzbarkeit durch Druckfarbe aufgerauht oder anderweitig vorbehandelt sein kann. Weiterhin sind bekannte Druckplattenträger aus Papier geeignet, das hier nicht unbedingt naßfest zu sein braucht. Auch gummielastische Trägermaterialien sind geeignet; mit solchen Trägern kann auch im direkten Flachdruck gedruckt werden.

Das Trägermaterial dient bei den Druckformen, die aus dem erfindungsgemäßen Material hergestellt werden, im Gegensatz zu sonst üblichen Druckformen, als farbführendes Material. Die nach dem Belichten und Entwickeln stehengebliebene Silikongummischicht dient als Bildhintergrund und wirkt in trockenem Zustand farbabstoßend. Zum Druck können dabei sowohl übliche Druckfarben auf Olbasis als auch spezielle hydrophile Druckfarben dienen, wie sie für den wasserlosen Offsetdruck sowie für den umgekehrten Offsetdruck entwickelt wurden und im Handel erhältlich sind. Da die meisten gebräuchlichen Schichtträgeroberflächen, z. B. aufgerauhtes oder anodisch oxydiertes Aluminium, stark hydrophil sind, werden hydrophile Druckfarben mit Vorteil eingesetzt.

Die Herstellung der erfindungsgemäßen Druckplatten erfolgt in bekannter Weise. Der Druckplattenträger wird zunächst mit der lichtempfindlichen Beschichtungslösung wie üblich beschichtet. Man trocknet die Schicht nur schwach und trägt dann das netzmittelhaltige verdünnte Kieselsäuresol an. Auf die getrocknete Kieselsäureschicht trägt man schließlich die Polysiloxanlösung auf, die ggf. Vernetzer und Katalysatoren enthält, trocknet und vernetzt die Schicht durch mehrstündiges Lagern bei Raumtemperatur (RTV-1-Kautschuk) oder durch mäßiges Erwärmen, z. B. 1 Minute lang bei 100 bis 120° C, und zusätzliche mehrstündige Lagerung im Dunkeln bei Raumtemperatur (RTV-2-Kautschuk).

Aus dem vorsensibilisierten Material erhält man eine druckfertige Flachdruckform durch Belichten unter einer Negativ-Filmvorlage und durch Entwickeln. Zur Belichtung eignen sich z. B. Quecksilberlampen, Kohlenbogenlampen, Metallhalogenidlampen, Xenon-Lampen, Leuchtröhrengeräte, Lasergeräte, Elektronenstrahlröhren und andere bekannte Belichtungsgeräte. Wenn die Säure bildende Verbindung der strahlungsempfindlichen Schicht nicht gegen sichtbares oder ultraviolettes Licht, wohl aber gegen energiereiche Strahlung, z. B. Röntgen-oder Korpuskularstrahlung, empfindlich ist, werden entsprechende Strahlungsquellen verwendet. Beim Entwicklungsvorgang wird die abhäsive Silikongummischicht von der Entwicklerlösung angequollen, und die belichteten Partien der strahlungsempfindlichen Schicht werden darin aufgelöst. Beim Abreiben mit einem weichen Material, z. B. Watte, Textilien oder Schaumgummi, brechen die über den gelösten bestrahlten Stellen der Schicht liegenden Bereiche der gequollenen Silikongummischicht aus. Dabei wird die Oberfläche des Druckplattenträgers freigelegt. Die freigelegte Oberfläche nimmt Druckfarbe leicht an, während die erhalten gebliebene Silikonschicht die Farbe abstößt. Das Einfärben der entwickelten Platte kann in oder außerhalb der Druckmaschine erfolgen.

Brauchbare Entwickler müssen sowohl die Abhäsivschicht stark aufquellen und rasch durchdringen, als auch die belichteten Bezirke der lichtempfindlichen Schicht gut entwickeln. Dabei dürfen die unbelichteten Bereiche nicht angegriffen werden. Gute Ergebnisse erzielt man mit Gemischen aus wassermischbaren Lösemitteln und Wasser, das ggf. mit Basen, basischen Salzen, Ammoniak oder Aminen schwach alkalisch gemacht wurde. Geeignete wasserlösliche Lösemittel finden sich unter den niederen Alkoholen, Glykolen, Glykolethern, Ketonen und cyclischen Ethern. Vorzugsweise verwendet man schwach alkalisch eingestellte Isopropanol/Wasser-Gemische mit einem Wasseranteil von über 50 % und mit einem pH-Wert zwischen 8 und 9.

Die beim Entwickeln freigelegte, farbführende Träger-oberfläche liegt wenige Mikrometer tiefer als die farb abstoßenden Nichtbildbereiche. Die Vertiefungen können durch Aufwalzen von Druckfarbe ausgefüllt werden. Nach Trocknen der Farbe liegen die farbannehmenden und farbabstoßenden Bereiche auf gleicher Ebene.

Die folgenden Beispiele beschreiben bevorzugte Ausführungsformen der erfindungsgemäßen Druckplatte. Mengenverhältnisse und Prozentzahlen sind, wenn nichts anderes angegeben ist, in Gewichtseinheiten zu verstehen. Die Herstellung und Verarbeitung der vorsensibilisierten Druckplatten erfolgte bei Gelblicht.

## Beispiel 1

Eine Lösung aus

4,0 g Kresol-Formaldehyd-Novolak (Schmelzpunkt 105 - 120 C),
1,2 g Polyacetal aus Triethylenglykol und 2-Ethyl-butyraldehyd,
0,2 g 2-Stilbenyl-4,6-bis-trichlormethyls-triazin und
0,032 g Kristallviolettbase in 80g Butanon

wurde bei ca. 60 U/min auf eine durch Bürsten aufgerauhte Aluminiumfolie aufgeschleudert und mittels Warmluft angetrocknet (Schichtgewicht nach völligem Trocknen 1,1 g/m$^2$). Direkt nach ihrer Verfestigung wurde die noch lösemittelhaltige Schicht mit folgender Lösung durch Schleudern überschichtet:

97 g entsalztes Wasser,
3 g 30 %iges anionisches Kieselsäuresol mit einem pH-Wert von ca. 10 und einer Teilchengröße von 25 - 30 nm.
0,07 g Diisobutyl-naphthalinsulfonsaures Natrium.

Der Teller der Plattenschleuder hatte dabei eine Drehzahl von etwa 150 U/Minute. Nach Trocknen beider Schichten wurde - bei ca. 60 U/Minute - nachstehende Lösung aufgeschleudert:

84 g aliphatisches Kohlenwasserstoffgemisch, Siedebereich 116 - 142° C,
15 g einer 33 %igen Lösung eines Dihydroxypolydimethylsiloxans in Toluol, Viskosität bei 25° C = 9.000 bis 15.000 mPa•s,
0,7 g Vinyl-triacetoxysilan,
0,3 g Dibutylzinndiacetat.

Die Schicht wurde getrocknet und durch 1-minütiges Erwärmen im Trockenschrank auf 110° C vulkanisiert.

Die so gewonnene vorsensibilisierte Druckplatte wurde unter einer Negativ-Filmvorlage 15 s mit einer 5 kW-Metallhalogenid-Lampe im Abstand von 140 cm belichtet, danach 75 s in eine Entwicklerflüssigkeit eingetaucht und schließlich mit einem weichen Wattebausch abgerieben. Dabei lösten sich alle drei Schichten an den belichteten Stellen ab. Der verwendete Entwickler bestand aus

71,72 % entsalztem Wasser,
28,23 % Isopropanol,
0,022 % n-Butanol,
0,013 % NaOH und
0,011 % $Na_2SiO_3$•9 $H_2O$.

In einer Kleinoffsetdruckmaschine, aus der das Feuchtwerk entfernt worden war, ließ sich die Druckform mit handelsüblicher Waterless-Offset-Druckfarbe leicht ein-färben. Beim Drucken lieferte sie saubere Abzüge.

## Beispiel 2

Beispiel 1 wurde wiederholt mit folgender lichtempfindlicher Beschichtungslösung:

80 g Butanon,
4 g Kresol-Formaldehyd-Novolak (Schmelzpunkt 105 - 120° C),
0,2 g des in Beispiel 1 angegebenen Polyacetals,
0,2 g 2-(4-Ethoxy-naphth-1-yl)-4,6-bis-trichlormethyl-s-triazin und
0,03 g Kristallviolettbase.

Die entwickelte Druckform lieferte in der Druckmaschine sehr saubere, scharfe Drucke.

## Beispiel 3

Beispiel 1 wurde mit der nachstehenden lichtempfindlichen Beschichtungslösung wiederholt:

80 g Butanon,
4 g Kresol-Formaldehyd-Novolak
(Schmelzpunkt 105 - 120° C),
0,3 g eines Polykondensats aus Orthoameisensäuremethylester und 2-Ethyl-2-hydroxymethyl-4-oxa-1,8-octandiol,
0,2 g 2-Acenaphth-5-yl-4,6-bis-trichlormethyls-triazin und
0,03 g Kristallviolettbase.

Die entwickelte Form wurde mit Waterless-OffsetDruckfarbe eingewalzt und nach Trocknen der Farbe in einer Kleinoffsetdruckmaschine verdruckt. Dabei wurden sehr saubere, scharfe Drucke erhalten.

## Beispiel 4

Eine durch Bürsten aufgerauhte Aluminiumfolie wurde nacheinander mit der in Beispiel 2 angegebenen Beschichtungslösung und mit dem in Beispiel 1 beschriebenen Kieselsäuresol beschichtet. Die Dehäsivschicht wurde durch Aufschleudern folgender Lösung gewonnen:

84 g Kohlenwasserstoffgemisch wie in Beispiel 1,
15 g der in Beispiel 1 angegebenen Dihydroxypolydimethylsiloxanlösung,
0,35 g Vinyl-triacetoxysilan,
0,35 g Methacryloyloxypropyl-trimethoxysilan und
0,3 g Dibutylzinndiacetat.

Bei Verarbeitung nach den Angaben in Beispiel 1 wurden über 5.000 sehr saubere Drucke erhalten.

## Beispiel 5

Beispiel 4 wurde wiederholt, anstelle von Methacryloyloxypropyl-trimethoxysilan wurde aber Tetraethylorthosilikat eingesetzt. Die Druckform lieferte saubere Drucke.

## Beispiel 6

Beispiel 2 wurde in der Weise abgeändert, daß in der Polysiloxanschicht anstelle von 0,7 g nur 0,2 g Vinyltriacetoxysilan verwendet wurden. Die Druckplatte ließ sich leicht entwickeln. Sie lieferte sehr saubere Drucke.

## Beispiel 7

Eine durch Bürsten aufgerauhte Aluminiumfolie wurde wie in Beispiel 2 mit einer lichtempfindlichen Schicht und einer Kieselsäureschicht versehen. Auf das Material wurde eine Mischung aus 1 Gewichtsteil einer 75 %igen Lösung eines an der Luft selbstvernetzenden Polysiloxans vom Amintyp in Toluol (Viskosität ca. 9.000 mPa•s) und 4 Gt des in Beispiel 1 angegebenen aliphatischen Kohlenwasserstoffgemischs in der Weise aufgetragen, daß nach dem Trocknen ein Schichtgewicht von ca. 5 g/m² resultierte. Durch mehrstündiges Lagern an der Luft wurde die Silikonschicht vernetzt.

Die Verarbeitung zur Druckform erfolgte nach den Angaben in Beispiel 1. Die Form lieferte auf der Kleinoffsetdruckmaschine tonfreie scharfe Drucke.

## Beispiel 8

Beispiel 7 wurde mit einem anderen unter der Einwirkung von Luftfeuchtigkeit vernetzenden Polysiloxan wiederholt. Auf die haftvermittelte lichtempfindliche Schicht wurde folgende Mischung aufgeschleudert:

12,5 g einer transparenten Dispersion aus 60 % aliphatischem Kohlenwasserstoffgemisch wie in Beispiel 1, Füllstoff und Polysiloxan vom Amin-Typ mit einer Viskosität von ca. 1.500 mPa•s,
87,5 g des gleichen Kohlenwasserstoffgemischs.

Die Schicht hatte nach dem Trocknen ein Schichtgewicht von 2,2 g/m². Sie wurde durch mehrstündiges Lagern an der Luft vernetzt.

Die entwickelte Form lieferte saubere und - scharfe Drucke.

## Beispiel 9

Eine mechanisch aufgerauhte Aluminiumfolie wurde mit der in Beispiel 2 beschriebenen Beschichtungslösung beschichtet. Auf die unvollständig getrocknete Schicht wurde folgende Lösung aufgeschleudert:

97,0 g entsalztes Wasser,
3,0 g 30 %iges, kationisches Kieselsäuresol
mit einem pH-Wert von ca. 3,9,
0,04 g n-Nonylphenolpolyglykolether.

Die getrocknete Kieselsäure-Schicht wurde wie in Beispiel 1 mit Silikonkautschuk überzogen.

Beim Belichten und Entwickeln der Platte - wie in Beispiel 1 angegeben - löste sich an den belichteten Stellen nur die Silikongummischicht ab, so daß die darunterliegende, farbannehmende Kopierschicht freigelegt wurde.

In einer Kleinoffset-Druckmaschine lieferte die entwickelte Form scharfe, saubere Drucke in hoher Stückzahl.

Beispiel 10 (Vergleichsbeispiel)

Beispiel 1 wurde wiederholt, zur Herstellung der haftvermittelnden Zwischenschicht aber nicht das angegebene Kieselsäuresol verwendet, sondern eine 3 %ige Lösung von Vinyl-triacetoxy-silan in einem aliphatischen Kohlenwasserstoffgemisch, Siedebereich 116 - 142° C.

Beim Entwickeln der bildmäßig belichteten Platte wurden nicht nur die belichteten Stellen abgelöst, sondern auch die unbelichteten Bezirke merklich angegriffen. Infolge unzureichender Haftung der Silikongummi-Schicht konnten nur Druckformen mit beschädigten Bildstellen erhalten werden.

Beispiel 11 (Vergleichsbeispiel)

Beispiel 1 wurde wiederholt, anstelle des Kieselsäuresols aber eine 3 %ige Lösung von 3-(2-Aminoethylamino)propyl-trimethoxy-silan in einem aliphatischen Kohlenwasserstoffgemisch, Siedebereich 116-142° C, eingesetzt.

Beim Belichten der Platte trat keine Löslichkeitsdifferenzierung in der Kopierschicht ein, folglich konnte kein Bild entwickelt werden.

**Ansprüche**

1. Vorsensibilisierte Druckplatte für den wasserlosen Flachdruck mit einem Schichtträger, einer durch Belichtung löslich werdenden strahlungsempfindlichen Schicht, einer äußeren, Druckfarbe abweisenden vernetzten Silikonkautschukschicht und einer Zwischenschicht, die die Haftung der Silikonkautschukschicht auf der strahlungsempfindlichen Schicht verbessert, dadurch gekennzeichnet, daß die strahlungsempfindliche Schicht als wesentliche Bestandteile

a) eine Verbindung mit mindestens einer durch Säure spaltbaren C-O-C-Bindung,

b) eine bei Bestrahlung eine starke Säure bildende Verbindung und

c) ein in Wasser unlösliches Bindemittel

enthält und die Zwischenschicht aus amorpher Kieselsäure besteht.

2. Druckplatte nach Anspruch 1, dadurch gekennzeichnet, daß die Zwischenschicht durch Auftragen und Trocknen eines wäßrigen Kieselsäuresols erhalten worden ist.

3. Druckplatte nach Anspruch 2, dadurch gekennzeichnet, daß das Kieselsäuresol ein wasserlösliches Netzmittel enthält.

4. Druckplatte nach Anspruch 1, dadurch gekennzeichnet, daß die Zwischenschicht ein Flächengewicht von 0,01 bis 1 g/m$^2$ hat.

5. Druckplatte nach Anspruch 1, dadurch gekennzeichnet, daß die Verbindung mit mindestens einer durch Säure spaltbaren C-O-C-Bindung ein Orthocarbonsäurederivat, ein Acetal, ein Enolether oder ein N-Acyl-iminocarbonat ist.

6. Druckplatte nach Anspruch 1, dadurch gekennzeichnet, daß das wasserunlösliche Bindemittel in wäßrigalkalischen Lösungen löslich ist.

7. Druckplatte nach Anspruch 6, dadurch gekennzeichnet, daß das Bindemittel ein Novolak ist.

8. Druckplatte nach Anspruch 1, dadurch gekennzeichnet, daß der Silikonkautschuk ein bei Raumtemperatur vernetzbarer Zweikomponentenkautschuk ist.

9. Druckplatte nach Anspruch 8, dadurch gekennzeichnet, daß der Silikonkautschuk als Vernetzer ein Alkenyl-triacetoxy-silan enthält.

10. Druckplatte nach Anspruch 1, dadurch gekennzeichnet, daß die Silikongummischicht ein Flächengewicht von 1 bis 20 g/m$^2$ hat.

11. Verfahren zur Herstellung einer Druckform für den wasserlosen Flachdruck, dadurch gekennzeichnet, daß man eine vorsensibilisierte Flachdruckplatte gemäß Anspruch 1 bildmäßig belichtet, in eine ein mit Wasser mischbares organisches Lösungsmittel enthaltende wäßrige Lösung eintaucht und danach an den belichteten Stellen die lichtempfindliche Schicht zusammen mit der darüberliegenden Silikongummischicht durch Reiben entfernt.

12. Verfahren nach Anspruch 11, dadurch gekennzeichnet, daß die wäßrige Lösung alkalisch ist.

13. Verfahren nach Anspruch 11, dadurch gekennzeichnet, daß die wäßrige Lösung mindestens 50 % Wasser enthält.